# EUROPEAN PATENT APPLICATION

(11) **EP 4 810 221 A1**
(43) Date of publication of application: **23.09.2026**
(21) Application number: 24891267.7
(22) Date of filing: 01.11.2024
(51) Int. Cl.: B29C 43/20, B29C 70/42, B32B 15/08, B32B 17/04, H01L 23/14, H05K 1/03

(54) **PRODUCTION METHODS FOR LAMINATE, LAMINATED BOARD, PRINTED WIRING BOARD, AND SEMICONDUCTOR PACKAGE**

(30) Priority: 13.11.2023 JP 2023193016
(71) Applicant: Resonac Corporation, Tokyo 105-7325 (JP)
(72) Inventor: FUJITA, Hiroaki, Tokyo 105-7325 (JP); KITAJIMA, Takayo, Tokyo 105-7325 (JP); TONOUCHI, Shunsuke, Tokyo 105-7325 (JP); IKEBA, Kasumi, Tokyo 105-7325 (JP)
(74) Representative: Hoffmann Eitle
(86) International application number: PCT/JP2024/039165
(87) International publication number: WO 2025/105228

(57) **Abstract**

Methods for producing a laminated article and a laminate including an internal glass film that is resistant to breakage are provided. A method for producing a printed wiring board and a method for producing a semiconductor package that use the method for producing a laminate are provided. The method for producing a laminated article includes the following step (1): (1) disposing a prepreg having a surface waviness (Wa) of 5.0 µm or less, on one surface or both surfaces of a glass film, so as to produce a laminated article.

## Description

### Technical Field

The present disclosure relates to methods for producing a laminated article, a laminate, a printed wiring board, and a semiconductor package.

### Background Art

In association with the increased density of semiconductor packages and the increased communication rate in recent years, a semiconductor package is demanded to have lower warpage. The known methods for exhibiting low warpage of a semiconductor package include a method of adding an inorganic filler to the resin layer of the laminate for the printed wiring board, so as to achieve low thermal expansion, but the limitation existing in the content of the inorganic filler leads to the limitation in achieving low thermal expansion by the method.

Under the circumstances, for the purpose of exhibiting higher dimensional stability by regulating the thermal expansion coefficient of the printed wiring board, a laminate having a resin layer and a copper foil on both sides of a glass film, i.e., having a configuration of "copper foil/resin layer/glass film/resin layer/copper foil", is proposed (see PTL 1).

### Citation List

### Patent Literature

PTL 1: JP 4657554 B

### Summary of Invention

### Technical Problem

However, the investigations by the present inventors have revealed that the laminate having a configuration of "copper foil/resin layer/glass film/resin layer/copper foil" has a tendency that the internal glass film is readily broken in transporting, handling, cutting, and the like, resulting in a deteriorated yield.

In view of the situation, an object of the present disclosure is to provide methods for producing a laminated article and a laminate including an internal glass film that is resistant to breakage, and to provide a method for producing a printed wiring board and a method for producing a semiconductor package that use the method for producing a laminated article or a laminate.

### Solution to Problem

As a result of earnest investigations by the present inventors, it has been found that the object can be achieved by the present disclosure. The present disclosure includes the following embodiments [1] to [8].
[1] A method for producing a laminated article, including the following step (1):
   (1) disposing a prepreg having a surface waviness (Wa) of 5.0 µm or less, on one surface or both surfaces of a glass film, so as to produce a laminated article.
[2] The method for producing a laminated article according to the item [1], in which the prepreg used in the step (1) is produced by impregnating a fiber substrate with a thermosetting resin film.
[3] The method for producing a laminated article according to the item [1] or [2], in which in the step (1), the glass film has a thickness of 50 to 1,000 µm.
[4] The method for producing a laminated article according to any one of the items [1] to [3], in which in the step (1), the prepreg has a thickness of 10 to 300 µm.
[5] A method for producing a laminate, including the following steps (1) and (2) in this order:
   (1) disposing a prepreg having a surface waviness (Wa) of 5.0 µm or less, on one surface or both surfaces of a glass film, so as to produce a laminated article, and
   (2) disposing a metal foil on one surface or both surfaces of the laminated article, and then molding under heat and pressure, so as to produce a laminate.
[6] The method for producing a laminate according to the item [5], in which the method further includes the following step (1') between the step (1) and the step (2):
   (1') disposing a glass film on one surface or both surfaces of the laminated article obtained in the step (1), and then disposing the prepreg on the glass film, or repeating the step (1') twice or more, so as to produce a laminated article.
[7] A method for producing a printed wiring board, including forming a wiring pattern on a laminate produced by the production method according to the item [5] or [6].
[8] A method for producing a semiconductor package, including mounting a semiconductor device on a printed wiring board obtained by the production method according to the item [7], and then encapsulating the semiconductor device with an encapsulation resin.

### Advantageous Effects of Invention

The present disclosure can provide methods for producing a laminated article and a laminate including an internal glass film that is resistant to breakage, and a method for producing a printed wiring board and a method for producing a semiconductor package that use the method for producing a laminated article or a laminate.

### Brief Description of Drawings

[Fig. 1]

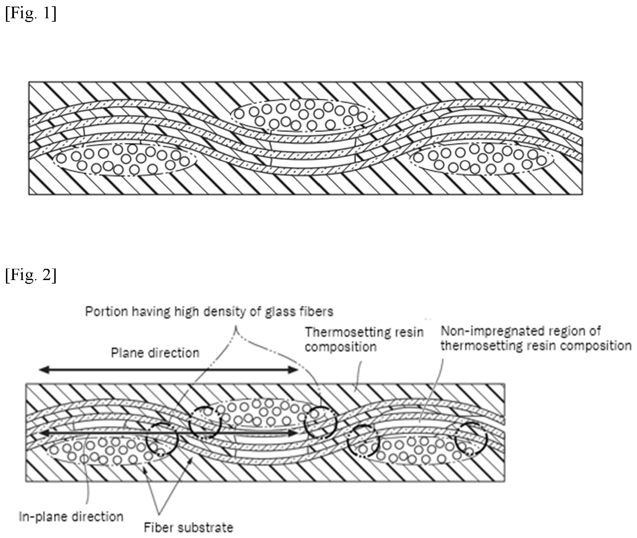

   Fig. 1 is a schematic cross sectional view showing one embodiment of a prepreg used in the present embodiment.
[Fig. 2]
   Fig. 2 is a schematic cross sectional view for describing one embodiment of a prepreg used in the present embodiment.
[Fig. 3]

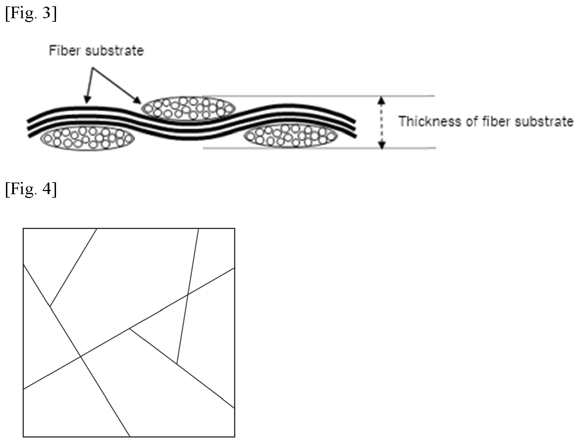

   Fig. 3 is a cross sectional view of a fiber substrate included in a prepreg used in the present embodiment for describing the thickness of the fiber substrate.
[Fig. 4]
   Fig. 4 is a top view of a copper-clad laminate showing the state observed in the case where the internal glass film of the copper-clad laminate is fractured in Example or Comparative Example.
[Fig. 5]

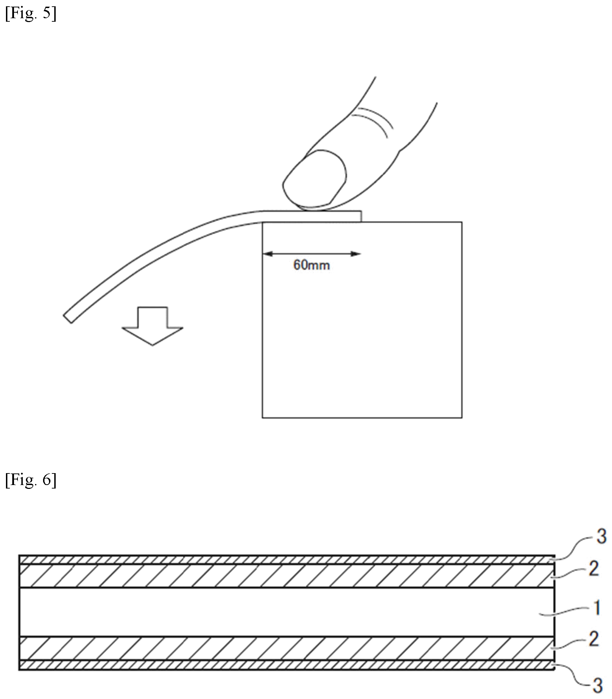

   Fig. 5 is a schematic view for describing the evaluation method of the handleability of the copper-clad laminate in Examples and Comparative Examples.
[Fig. 6]
   Fig. 6 is a schematic cross sectional view showing the structure of the copper-clad laminate produced in Example 1 or 2.
[Fig. 7]

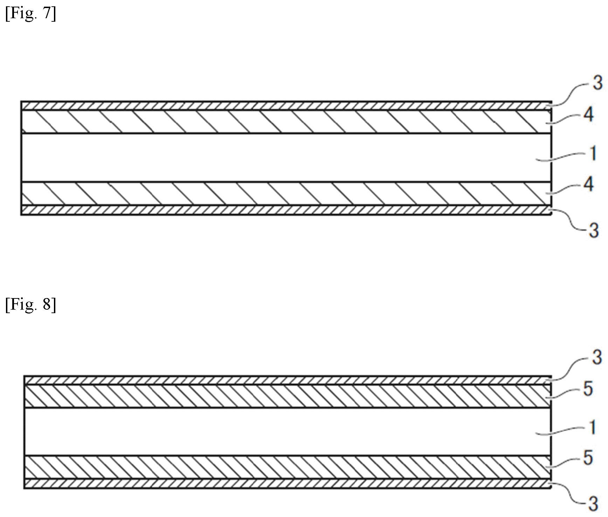

   Fig. 7 is a schematic cross sectional view showing the structure of the copper-clad laminate produced in Comparative Example 1 or 2.
[Fig. 8]
   Fig. 8 is a schematic cross sectional view showing the structure of the copper-clad laminate produced in Comparative Example 3.

### Description of Embodiments

One embodiment of the present disclosure will be described below, but the present disclosure is not limited to the embodiment described below.

In the numerical range described in the present disclosure, the lower limit value or the upper limit value of the numerical range may be replaced by the value described in the examples. The lower limit value and the upper limit value of the numerical range may be optionally combined with the lower limit value and the upper limit value of another numerical range. In the expression "AA to BB" for the numerical range, both the end values AA and BB are included in the numerical range.

In the present disclosure, for example, the expression "10 or more" means 10 and a value exceeding 10, and this is also applied to the cases of other values. Furthermore, for example, the expression "10 or less" means 10 and a value of less than 10, and this is also applied to the cases of other values.

As for each of the components and materials exemplified in the present disclosure, one kind thereof may be used alone, or two or more kinds thereof may be used in combination, unless otherwise indicated. In the present disclosure, in the case where multiple substances exist for each of the contents of the components in the thermosetting resin composition, the content of the component in the thermosetting resin composition means the total amount of the multiple substances existing in the thermosetting resin composition unless otherwise indicated.

In the present disclosure, the "resin component" is defined as all the components of the solid content constituting the thermosetting resin composition except for the inorganic compound, such as the inorganic filler, the flame retardant, and the flame retardant aid, which are described later.

In the present disclosure, the "solid content" means the components except for the solvent, and a component that is in the form of liquid at 25°C is also assumed to be the solid content.

In the present disclosure, in the case where XX is capable of being reacted, the expression "containing XX" encompasses the case where reacted XX is contained, or the case where XX is simply contained, and also encompasses both the cases.

In the present disclosure, an embodiment including an optional combination of the matters described therein is also encompassed by the present disclosure and the present embodiment.

### [Method for producing Laminated Article and Method for producing Laminate]

One embodiment of the present embodiment is a method for producing a laminated article, including the following step (1):
(1) disposing a prepreg having a surface waviness (Wa) of 5.0 µm or less, on one surface or both surfaces of a glass film, so as to produce a laminated article.

Another embodiment of the present embodiment is a method for producing a laminate, including the following steps (1) and (2) in this order:
(1) disposing a prepreg having a surface waviness (Wa) of 5.0 µm or less, on one surface or both surfaces of a glass film, so as to produce a laminated article, and
(2) disposing a metal foil on one surface or both surfaces of the laminated article, and then molding under heat and pressure, so as to produce a laminate.

The steps (1) and (2) will be described in this order below.

### (1) Production of Laminated Article

### <Prepreg>

The prepreg used in the step (1) has a surface waviness (Wa) of 5.0 µm or less. The prepreg used is not particularly limited, and can be a prepreg including a fiber substrate having an impregnated region and a non-impregnated region with a thermosetting resin composition (see Figs. 1 and 2). It is considered that the small surface waviness of the prepreg used in the step (1) enables the production of the laminated article and the laminate including an internal glass film that is resistant to breakage. The region that is not impregnated with the thermosetting resin composition is intentionally provided in the fiber substrate, and thereby it is estimated that the layer of the thermosetting resin composition (which may be hereinafter abbreviated as a resin layer) in the vicinity of the surface is allowed to exist not along the waviness of the glass cloth, and as a result, the waviness of the fiber substrate is prevented from appearing on the surface of the prepreg, which facilitates the reduction of the surface waviness of the prepreg.

The prepreg can be produced by impregnating a fiber substrate with a thermosetting resin film. On the other hand, a method of impregnating a fiber substrate with a resin varnish, followed by drying, readily allows the thermosetting resin composition to follow the waviness of the glass cloth, so as to increase the surface waviness of the prepreg, and therefore the prepreg having a surface waviness (Wa) of 5.0 µm or less used in the present embodiment is difficult to produce thereby.

The surface waviness (Wa) of the prepreg is 5.0 µm or less as described above, is preferably 3.0 µm or less, more preferably 2.5 µm or less, and further preferably 2.0 µm or less, and may be 1.5 µm or less. The lower limit value of the surface waviness (Wa) of the prepreg is not particularly limited, may be 0.01 µm or more, may be 0.1 µm or more, and may be 0.2 µm or more. Accordingly, the surface waviness (Wa) of the prepreg of the present embodiment may be 0.01 to 5.0 µm.

The surface waviness (Wa) in the present disclosure is the arithmetic average height (Wa) that can be obtained from the waviness curve according to ISO 4287 (1997). JIS B0601 (2001) may be used instead of ISO 4287 (1997). The surface waviness (Wa) in the present disclosure can be measured in the following manner.

The shape measurement is automatically performed with the observation application of a profile analysis laser microscope "VK-X100" (available from Keyence Corporation) to provide a waviness curve according to ISO 4287 (1997) or JIS B0601 (2001). The resulting waviness curve is analyzed for the surface roughness with the analysis application thereof to calculate the surface waviness (Wa). The waviness curve herein is a curve obtained by removing the component having a wavelength of less than 80 µm from the cross sectional curve by applying a phase compensation high-pass filter λc (λc = 80 µm) on the cross sectional curve. The analysis region is 1,000 µm × 1,000 µm.

Even though not specified, the surface waviness (Wa) of the prepreg in the present disclosure is the surface waviness of both surfaces of the prepreg, and the "surface" herein means the surface of the prepreg that is to be adhered in the case where multiple prepregs are laminated to produce a laminated article or a metal-clad laminate, or the surface thereof opposite thereto, but the side surface is not encompassed.

In the present disclosure, the "plane direction" of the prepreg means the direction along the plane of the prepreg on the surface of the prepreg as shown in Fig. 2. In the present disclosure, the "in-plane direction" means the direction along the surface of the fiber substrate inside the fiber substrate as shown in Fig. 2. Both the "plane direction" and the "in-plane direction" are in parallel to the direction from one edge of the prepreg toward an edge opposite to the edge approximately perpendicularly thereto. In the present disclosure, approximately perpendicular means substantially perpendicular, and approximately perpendicular is preferably 86 to 94°, more preferably 88 to 92°, further preferably 89 to 91°, and particularly preferably 90°.

### (Existence of Non-impregnated Region with Thermosetting Resin Composition in Fiber Substrate)

As described above, it is preferred that the prepreg has an impregnated region and a non-impregnated region with the thermosetting resin composition in the fiber substrate, and it is more preferred that the non-impregnated region exists, and preferably the non-impregnated region exist intermittently. The existence of the non-impregnated region can be confirmed by determining the existing ratio of the impregnated region with the thermosetting resin composition in the fiber substrate. Specifically, the existing ratio of the impregnated region that does not reach 100% means the existence of the non-impregnated region.

In the present embodiment, the existing ratio of the impregnated region with the thermosetting resin composition in the fiber substrate is not particularly limited, may be 30 to 98%, may be 30 to 95%, may be 40 to 95%, may be 50 to 90%, and may be 60 to 85%. In the case where the existing ratio of the impregnated region is 30% or more, the non-impregnated region is likely to exist intermittently, and from the standpoint, the existing ratio of the impregnated region is preferably 50% or more.

### (Surface Roughness (Ra))

The prepreg preferably has a surface roughness (arithmetic average roughness: Ra, which may be hereinafter referred simply to as "Ra") of 0.1 to 5 µm, while not particularly limited.

The surface roughness (Ra) in the present disclosure is the arithmetic average height (Ra) that can be obtained from the roughness curve according to ISO 4287 (1997). JIS B0601 (2001) may be used instead of ISO 4287 (1997). The surface roughness (Ra) in the present disclosure is a surface roughness (Ra) that is obtained by measuring with a profile analysis laser microscope "VK-X100" (available from Keyence Corporation). The roughness curve is a curve obtained by removing the component having a wavelength of more than 80 µm from the cross sectional curve by applying a phase compensation high-pass filter λc (λc = 80 µm) on the cross sectional curve. The analysis region is 1,000 µm × 1,000 µm.

The prepreg of the present embodiment that has Ra of 0.1 µm or more has suitable unevenness on the surface of the prepreg imparted thereby, which provides a tendency that the static charge amount can be suppressed low, resulting in excellent handleability. On the other hand, Ra of 5 µm or less can provide a tendency that the thickness accuracy of the metal-clad laminate is enhanced.

From the standpoint, Ra of the prepreg may be 0.15 to 3 µm, may be 0.2 to 2 µm, may be 0.2 to 1.6 µm, may be 0.2 to 1.0 µm, and may be 0.2 to 0.7 µm.

Even through not specified, Ra of the prepreg in the present disclosure is Ra of at least one surface of the prepreg, and the "surface" herein means the surface of the prepreg that is to be adhered in the case where multiple prepregs are laminated to produce a laminated article or a metal-clad laminate, or the surface thereof opposite thereto, but the side surface is not encompassed. It is preferred that Ra of at least one surface of the prepreg is in the aforementioned range, and it is more preferred that Ra of both surfaces thereof each are in the aforementioned range.

### (Fiber Substrate)

The fiber substrate included in the prepreg used in the step (1) may be a known one used in various laminates for an electric insulating material. Examples of the material of the fiber substrate include natural fibers, such as paper and cotton linters; inorganic fibers, such as glass fibers and asbestos; organic fibers, such as aramid, polyimide, polyvinyl alcohol, polyester, tetrafluoroethylene, and acrylic; and mixtures thereof. Among these, inorganic fibers are preferred, and glass fibers are more preferred, from the standpoint of the flame retardancy. Examples of the glass fibers include a glass cloth using E glass, C glass, D glass, S glass, or the like; a glass cloth obtained by binding short fibers with a binder; and a mixed paper of glass fibers and cellulose fibers. Among these, the glass fibers are preferably a glass cloth using E glass.

The shape of the fiber substrate is not particularly limited, and may be a woven fabric, a nonwoven fabric, a roving, a chopped strand mat, a surfacing mat, or the like. The shape of the fiber substrate may be a woven fabric. The material and the shape thereof may be appropriately selected depending on the purpose and the capabilities of the target molded article. One kind of the fiber substrate may be used alone, or two or more kinds of materials and two or more kinds of shapes may be used in combination depending on necessity.

The fiber substrate may be a fiber substrate formed of one layer, or may be a fiber substrate including multiple layers. The fiber substrate formed of one layer means a fiber substrate that is formed only of entangled fibers, and the case where a fiber substrate having no entanglement exists is classified into the fiber substrate including multiple layers. The materials and the shapes of the two or more layers of the fiber substrate each may be the same as or different from each other.

The thickness of the fiber substrate (see Fig. 3) may be 10 to 300 µm, may be 10 to 200 µm, may be 10 to 150 µm, and may be 12 to 100 µm.

In the present disclosure, the thickness of the fiber substrate is the thickness of the position shown in Fig. 3, and is an average value of values obtained by measuring optional 5 positions of the fiber substrate with a micrometer.

### (Thermosetting Resin Composition)

The prepreg used in the step (1) includes the fiber substrate and a thermosetting resin composition as described above. The thermosetting resin composition contains at least a thermosetting resin. The components contained in the thermosetting resin composition are not particularly limited, and preferably include, in addition to the thermosetting resin, at least one selected from the group consisting of a curing agent, a curing accelerator, an inorganic filler, an organic filler, a coupling agent, a leveling agent, an antioxidant, a flame retardant, a flame retardant aid, a thixotropy imparting agent, a thickener, a flexible material, a surfactant, and a photopolymerization initiator.

The components contained in the thermosetting resin composition will be described below.

### (Thermosetting Resin)

Examples of the thermosetting resin include an epoxy resin, a polyimide resin, a maleimide resin, a modified maleimide resin, a phenol resin, a modified polyphenylene ether resin, a cyanate resin, an isocyanate resin, a benzoxazine resin, an oxetane resin, an amino resin, an unsaturated polyester resin, an allyl resin, a dicyclopentadiene resin, a silicone resin, a triazine resin, a bismaleimide-triazine resin, and a melamine resin.

Examples of the modified maleimide resin include a reaction product of a maleimide compound having at least two N-substituted maleimide groups and one or more kinds of a compound selected from the group consisting of a monoamine compound and a diamine compound. The maleimide resin herein does not encompass the modified maleimide resin. The modified polyphenylene ether resin is preferably a polyphenylene ether resin having an ethylenically unsaturated bond-containing group at an end thereof, and more preferably a polyphenylene ether resin having ethylenically unsaturated bond-containing groups at both ends thereof. Examples of the ethylenically unsaturated bond-containing group include an unsaturated aliphatic hydrocarbon group, such as a vinyl group, an allyl group, a 1-methylallyl group, an isopropenyl group, a 2-butenyl group, a 3-butenyl group, and a styryl group; and a group containing a hetero atom and an ethylenically unsaturated bond, such as a maleimide group and a (meth)acryloyl group.

The thermosetting resin is not particularly limited to the aforementioned examples, and known thermosetting resins may be used. One kind of the thermosetting resin may be used alone, or two or more kinds thereof may be used in combination.

From the standpoint of the moldability and the electric insulating capability, the thermosetting resin preferably contains one or more kinds selected from the group consisting of an epoxy resin, a polyimide resin, a maleimide resin, a modified maleimide resin, a cyanate resin, a modified polyphenylene ether resin, and a bismaleimide-triazine resin, and more preferably contains one or more kinds selected from the group consisting of an epoxy resin, a maleimide resin, a modified maleimide resin, and a cyanate resin.

The epoxy resin is preferably an epoxy resin having two or more epoxy groups in one molecule. The epoxy resin herein is classified into a glycidyl ether type epoxy resin, a glycidyl amine type epoxy resin, a glycidyl ester type epoxy resin, and the like. Among these, a glycidyl ether type epoxy resin is preferred.

The epoxy resin is also classified into various epoxy resins depending on the difference in main skeleton. For example, the aforementioned types of epoxy resins each are classified into a bisphenol type epoxy resin, an alicyclic epoxy resin, an aliphatic linear epoxy resin, a novolac type epoxy resin, a stilbene type epoxy resin, a naphthalene skeleton-containing epoxy resin, a biphenyl type epoxy resin, a xylylene type epoxy resin, a dihydroanthracene type epoxy resin, and the like. One kind of the epoxy resin may be used alone, or two or more kinds thereof may be used in combination from the standpoint of the insulation reliability and the heat resistance.

The epoxy resin may be a novolac type epoxy resin or may be a phenol-novolac type epoxy resin.

The content of the thermosetting resin in the thermosetting resin composition is preferably 5 to 80% by mass, more preferably 10 to 60% by mass, and further preferably 15 to 45% by mass, based on the total amount of the solid content.

### (Curing Agent)

For example, in the case where the thermosetting resin contains an epoxy resin, examples of the curing agent include a curing agent for an epoxy resin, such as a phenol-based curing agent, a cyanate ester-based curing agent, an acid anhydride-based curing agent, an amine-based curing agent, and an active ester group-containing compound. In the case where the thermosetting resin contains a resin other than an epoxy resin, a known curing agent for that thermosetting resin may be used. One kind of the curing agent may be used alone, or two or more kinds thereof may be used in combination.

Preferred examples of the phenol-based curing agent include a cresol-novolac type phenol resin, a biphenyl-aralkyl type phenol resin, a phenol-novolac type phenol resin, a naphthylene ether type phenol resin, and triazine skeleton-containing phenol resin, while not particularly limited.

Examples of the cyanate ester-based curing agent include bisphenol A dicyanate and polyphenyl cyanate (oligo(3-methylene-1,5-phenylenecyanate)), while not particularly limited.

Examples of the acid anhydride-based curing agent include phthalic anhydride, tetrahydrophthalic anhydride, trimellitic anhydride, and pyromellitic anhydride, while not particularly limited.

Examples of the amine-based curing agent include an aliphatic amine, such as triethylenetetramine and tetraethylenepentamine, and an aromatic amine, such as 4,4'-diaminodiphenylmethane, while not particularly limited.

A urea resin and the like may also be used as the curing agent.

In the case where the thermosetting resin composition contains the curing agent, the content thereof is preferably 20 to 200 parts by mass, more preferably 20 to 150 parts by mass, and further preferably 40 to 100 parts by mass, per 100 parts by mass of the thermosetting resin.

In the case where the thermosetting resin composition contains the curing agent, the content thereof may also be expressed in terms of functional group equivalent. Specifically, the content of the curing agent preferably satisfies the expression, ((mass of thermosetting resin)/(functional group equivalent)) ≈ ((mass of curing agent)/(functional group equivalent capable of reacting to thermosetting resin)) × constant C. The constant C varies depending on the kind of the functional group of the curing agent, and is preferably 0.8 to 1.2 for the case where the functional group is a phenolic hydroxy group, preferably 0.2 to 0.4 for the case where the functional group is an amino group, and preferably 0.3 to 0.6 for the case where the functional group is an active ester group.

In the case where the thermosetting resin contains an epoxy resin, the expression is ((mass of epoxy resin)/(epoxy group equivalent)) ≈ ((mass of curing agent)/(functional group equivalent capable of reacting to epoxy group)) × constant C.

### (Curing Accelerator)

The curing accelerator used can be an ordinary curing accelerator having been used for curing the thermosetting resin. For example, in the case where the thermosetting resin contains an epoxy resin, examples of the curing accelerator include an imidazole compound and a derivative thereof, a phosphorus compound, a tertiary amine compound, and a quaternary ammonium compound. An imidazole compound and a derivative thereof are preferred from the standpoint of accelerating the curing reaction.

Specific examples of the imidazole compound and a derivative thereof include an imidazole compound, such as 2-methylimidazole, 2-ethylimidazole, 2-undecylimidazole, 2-phenylimidazole, 1,2-dimethylimidazole, and 2,4-diamino-6-[2'-methylimidazolyl-(1')]ethyl-s-triazine; a salt of the imidazole compound and trimellitic acid, such as 1-cyanoethyl-2-phenylimidazolium trimellitate; a salt of the imidazole compound and isocyanuric acid; and a salt of the imidazole compound and hydrobromic acid. One kind of the imidazole compound and a derivative thereof may be used alone, or two or more kinds thereof may be used in combination.

The curing accelerator may be an imidazole compound and a derivative thereof, or may be an imidazole compound.

In the case where the thermosetting resin composition contains the curing accelerator, the content thereof is preferably 0.1 to 20 parts by mass, more preferably 0.1 to 10 parts by mass, and further preferably 0.5 to 5 parts by mass, per 100 parts by mass of the thermosetting resin.

### (Inorganic Filler)

An inorganic filler can reduce the thermal expansion coefficient and can enhance the coating film strength.

Examples of the inorganic filler include silica, alumina, barium sulfate, talc, mica, kaolin, boehmite, beryllia, barium titanate, potassium titanate, strontium titanate, calcium titanate, aluminum carbonate, magnesium hydroxide, aluminum hydroxide, aluminum borate, aluminum silicate, calcium carbonate, calcium silicate, magnesium silicate, zinc borate, zinc stannate, aluminum oxide, zirconia, mullite, magnesia, zinc oxide, titanium oxide, silicon carbide, silicon nitride, boron nitride, clay (such as baked clay), a molybdic acid compound (such as zinc molybdate), glass short fibers, glass powder, and hollow glass beads. Preferred examples of the glass as the material of glass short fibers, glass powder, and hollow glass beads include E glass, T glass, and D glass. One kind of the inorganic filler may be used alone, or two or more kinds thereof may be used in combination. Among these, from the standpoint of reducing the thermal expansion coefficient and reducing the relative permittivity and the dielectric tangent, silica and alumina are preferred, and from the standpoint of the heat resistance, aluminum hydroxide is preferred, and the combination use of silica and aluminum hydroxide is more preferred.

Examples of the silica include precipitated silica having a high water content produced by the wet method and dry method silica containing substantially no combined water or the like produced by the dry method. Examples of the dry method silica include crushed silica, fumed silica, and fused silica (molten spherical silica), which are classified by the difference in production method.

The inorganic filler may be subjected to a surface treatment with a surface treating agent, such as a silane coupling agent, for enhancing the moisture resistance, and may be subjected to a hydrophobizing treatment for enhancing the dispersibility.

In the case where the thermosetting resin composition contains the inorganic filler, the content thereof may be regulated depending on the purpose of the addition thereof, and is preferably 0.1 to 65% by volume based on the total amount of the solid content. With the content of 0.1% by volume or more based on the total amount of the solid content, there is a tendency that the thermal expansion coefficient can be reduced. By suppressing the content to 65% by volume or less, on the other hand, there is a tendency that the viscosity in mixing the resin component does not become too high, and the deterioration in workability can be easily suppressed from occurring. From the same standpoint, the content of the inorganic filler is more preferably 10 to 60% by volume, further preferably 15 to 55% by volume, and particularly preferably 30 to 55% by volume, based on the total amount of the solid content.

### (Coupling Agent)

A coupling agent contained can provide an effect of enhancing the dispersibility of the inorganic filler and the organic filler and enhancing the adhesiveness to the reinforcing base and the metal foil. One kind of the coupling agent may be used alone, or two or more kinds thereof may be used in combination.

The coupling agent may be a titanate coupling agent, a silane coupling agent, or the like.

### (Organic Solvent)

The thermosetting resin composition may further contain an organic solvent from the standpoint of enhancing the handleability. In the present disclosure, the thermosetting resin composition that contains an organic solvent may be referred to as a resin varnish.

Examples of the organic solvent include an alcohol-based solvent, such as methanol, ethanol, methyl cellosolve, butyl cellosolve, and propylene glycol monomethyl ether; a ketone-based solvent, such as acetone, methyl ethyl ketone, methyl isobutyl ketone, butanone, cyclohexanone, and 4-methyl-2-pentanone; an ester-based solvent, such as ethyl acetate, butyl acetate, propylene glycol monomethyl ether acetate, and γ-butyrolactone; an ether-based solvent, such as tetrahydrofuran; an aromatic-based solvent, such as toluene, xylene, and mesitylene; a nitrogen atom-containing solvent, such as N,N-dimethylformamide, N,N-dimethylacetamide, and N-methylpyrrolidone; and a sulfur atom-containing solvent, such as dimethyl sulfoxide, while not particularly limited.

One kind of the organic solvent may be used alone, or two or more kinds thereof may be used in combination.

For example, the content of the organic solvent is regulated to make a non-volatile content concentration of the thermosetting resin composition of preferably 20 to 85% by mass, and more preferably 40 to 80% by mass, from the standpoint of facilitating coating.

The method for preparing the thermosetting resin composition is not particularly limited, and an ordinarily known preparing method may be used.

For example, the thermosetting resin and depending on necessity the additional components are added to the organic solvent, which are then mixed and agitated with a mixer, so as to provide the resin varnish. Examples of the mixer include mixers of an ultrasonic dispersion type, a high-speed collision dispersion type, a high-speed rotation dispersion type, a bead mill type, a high-speed shear dispersion type, and a planetary centrifugal dispersion type.

### (Thickness of Prepreg)

The thickness of the prepreg used in the step (1) may be appropriately determined depending on the thickness of the fiber substrate and the like, may be 10 to 300 µm, may be 15 to 200 µm, may be 15 to 150 µm, may be 15 to 100 µm, may be 15 to 60 µm, and may be 20 to 40 µm. The thickness of the prepreg herein means the thickness of one ply of the prepreg.

In the present disclosure, the thickness of the prepreg is an average value of values obtained by measuring optional 5 positions thereof with Digimatic Indicator.

### (Method for producing Prepreg)

The method for producing the prepreg is not particularly limited, and can be produced by impregnating the fiber substrate with the thermosetting resin film as described above.

The resin film can be produced by forming a layer of the thermosetting resin composition (resin layer) on one surface of a release film. The resin layer can be formed, for example, by coating the resin varnish on one surface of a release film and then drying.

The method for coating the resin varnish is not particularly limited, and can be performed, for example, by using a known coating device, such as a comma coater, a bar coater, a kiss coater, a roll coater, a gravure coater, and a die coater. The coating device is preferably selected appropriately in consideration of the thickness of the resin layer.

The drying temperature and the drying time may vary depending on the amount of the organic solvent used and the boiling point of the organic solvent, and for example, in the case of the resin varnish containing 30 to 70% by mass of the organic solvent, the resin film can be favorably formed by drying at 50 to 160°C for 1 to 8 minutes.

The film formed in this manner may be referred to as a resin film with a release film.

### (Thickness of Resin Film)

The thickness of the resin film may be appropriately determined depending on the thickness of the prepreg and the like. For example, in the case where the thickness of the fiber substrate is in a range of 10 to 300 µm, the thickness of the resin film is preferably 3 to 200 µm, more preferably 5 to 150 µm, and further preferably 7 to 100 µm, may be 7 to 50 µm, and may be 7 to 30 µm. In the present disclosure, the thickness of the resin film is a value that is measured in the following manner. First, the total thickness of the film with the resin after coating is measured at optional 5 positions with Digimatic Indicator. At each of the measured positions, after removing the resin layer with an adhesive tape, the thickness of the release film is measured with Digimatic Indicator, and the values obtained by subtracting the thickness of the release film from the total thickness are averaged.

In the case where the thickness of the resin film is the lower limit value or more, there is a tendency that the amount of the resin for impregnating the glass cloth can be sufficiently secured. In the case where the thickness of the resin film is the upper limit value or less, there is a tendency that the resin film can be easily produced.

### (Release Film)

Examples of the release film include an organic film, such as polyethylene terephthalate (PET), biaxially stretched polypropylene (OPP), polyethylene, polyvinyl fluoride, and polyimide; and a metal or alloy film, such as copper and aluminum. The release film may be subjected to a release treatment with a release agent.

The thickness of the release film is not particularly limited, and is preferably 10 to 200 µm, more preferably 20 to 100 µm, and further preferably 30 to 70 µm, from the standpoint of the handleability in coating the thermosetting resin composition and the economic efficiency.

A commercially available product may also be used as the release film.

### (Method for impregnating Fiber Substrate with Resin Film)

A method of impregnating the fiber substrate with the resin film through lamination will be then described.

The resin film with the release film is disposed on at least one surface of the fiber substrate in such a manner that the resin film is brought into contact with the fiber substrate. Thereafter, the resin film with the release film thus disposed and the fiber substrate are heated and pressurized, and thereby the fiber substrate is impregnated with the resin film. At this time, it is preferred that the non-impregnated region with the thermosetting resin composition is provided intermittently in the fiber substrate.

The heating and pressurizing herein is preferably performed through lamination. Examples of the method of the lamination include roll lamination (a) and a lamination method under reduced pressure (b), such as a vacuum lamination method.

While the condition of the roll lamination (a) is not particularly limited, the heating temperature is preferably 80 to 180°C, and the pressurizing pressure (linear pressure) is preferably 0.05 to 1.0 MPa/m.

While the condition of the lamination method under reduced pressure (b) is not particularly limited, the heating temperature is preferably 50 to 170°C, and more preferably 110 to 160°C, the pressurizing time is preferably 10 to 120 seconds, and more preferably 20 to 80 seconds, and the pressurizing pressure is preferably 0.05 to 1.0 MPa, and more preferably 0.1 to 0.6 MPa.

### (Method for providing Non-impregnated Region)

It is preferred that the non-impregnated region with the thermosetting resin composition is provided in the fiber substrate as described above, and examples of the method therefor include a method of regulating the condition in heating and pressurizing the resin film with the release film and the fiber substrate, while not particularly limited. Specific examples thereof include a method of regulating the lamination condition.

Specific examples of the method of regulating the condition in heating and pressurizing include the following method, while not particularly limited. A prepreg is produced in advance under the prescribed heating and pressurizing condition, and the existing ratio of the impregnated region with the thermosetting resin composition in the fiber substrate is obtained based on the calculation method described above. As a result, in the case where the impregnated region is 100%, i.e., there is no non-impregnated region, a prepreg is again produced by decreasing the heating temperature or decreasing the pressurizing pressure, or by decreasing both the heating temperature and the pressurizing pressure, and the existing ratio of the impregnated region is again obtained. The procedure is repeated depending on necessity, and thereby the condition for producing the prepreg having the non-impregnated region preferably intermittently in the in-plane direction can be easily comprehended.

In the case where the existing ratio of the non-impregnated region is to be regulated lower, a prepreg is again produced by increasing the heating temperature or increasing the pressurizing pressure, or by increasing both the heating temperature and the pressurizing pressure.

The heating temperature is preferably 100 to 160°C, more preferably 110 to 160°C, and further preferably 120 to 150°C, from the standpoint of providing non-impregnated region with the thermosetting resin composition intermittently in the fiber substrate.

The pressurizing pressure is preferably 0.2 MPa or more, more preferably 0.2 to 1.0 MPa, further preferably 0.3 to 0.8 MPa, and particularly preferably 0.3 to 0.6 MPa, from the standpoint of providing non-impregnated region with the thermosetting resin composition intermittently in the fiber substrate.

In the case where the lamination is performed under reduced pressure, the existing ratio of the non-impregnated region can also be regulated by regulating the vacuum degree.

It is preferred that one or more plies of the resin film is disposed and laminated on each of both surfaces of the fiber substrate. The number of plies of the resin film is preferably one or two, and more preferably one, per one surface of the fiber substrate.

After impregnating the fiber substrate with the resin film, the resulting prepreg with the release film is cooled depending on necessity, and then the release film is released therefrom to produce the prepreg.

### (Production of Laminated Article)

In the step (1), the prepreg is disposed on one surface or both surfaces of a glass film, so as to produce a laminated article. The number of plies to be disposed may be one ply per one surface, or may be two or more plies per one surface. The prepreg is preferably disposed on both surfaces of the glass film.

Examples of the material of the glass film include E glass, C glass, D glass, and S glass, while not particularly limited.

The thickness of the glass film is not particularly limited, and is preferably 50 to 1,000 µm, more preferably 50 to 500 µm, further preferably 70 to 300 µm, particularly preferably 100 to 250 µm, and most preferably 120 to 200 µm.

An embodiment including the following step (1') between the step (1) and the step (2) is also preferred:
(1') disposing a glass film on one surface or both surfaces of the laminated article obtained in the step (1), and then disposing the prepreg on the glass film, or repeating the step (1') twice or more, so as to produce a laminated article.

A glass film is disposed on one surface or both surfaces of the laminated article obtained in the step (1), and then the prepreg is disposed on the glass film, thereby producing, for example, a laminated article having a configuration of "glass film/prepreg/glass film/prepreg", a laminated article having a configuration of "prepreg/glass film/prepreg/glass film/prepreg/glass film/prepreg", and the like.

Furthermore, after disposing a glass film on one surface or both surfaces of the laminated article obtained in the step (1), the step (1') is repeated n-times (n represents an integer of 2 or more), thereby producing, for example, a laminated article having a configuration of "glass film/prepreg(/glass film/prepreg)ₙ", a laminated article having a configuration of "(prepreg/glass film/)ₙ prepreg/glass film/prepreg(/glass film/prepreg)ₙ", and the like are produced.

### (2) Production of Laminate

A metal foil is disposed on one surface or both surfaces of the laminated article, which are then molded under heat and pressure, thereby producing a laminate. More specifically, it is possible that a metal foil is disposed to be in contact with the prepreg as the outermost layer of the laminated article, which are then molded under heat and pressure. For example, a configuration of "metal foil/prepreg/glass film/prepreg/metal foil" or the like can be molded under heat and pressure. It is preferred that metal foils are disposed on both surfaces of the laminated article, which are then molded under heat and pressure, and the laminate obtained by disposing metal foils on both surfaces of the laminated article, followed by molding under heat and pressure, may also be referred to as a metal-clad laminate.

Examples of the metal foil include a copper foil, an aluminum foil, a tin foil, a tin-lead alloy (solder) foil, and a nickel foil. The thickness of the metal foil may be a thickness that has been ordinarily used in laminates, and for example, may be 1 to 200 µm. A composite foil having a three-layer structure including an intermediate layer, such as nickel, nickel-phosphorus, a nickel-tin alloy, a nickel-iron alloy, lead, or a lead-tin alloy, having on both surfaces thereof a copper layer of 0.5 to 15 µm and a copper layer of 10 to 300 µm, and a composite foil having a two-layer structure including aluminum and a copper foil may also be used.

In the case where the metal foil is a copper foil, the metal-clad laminate is referred to as a copper-clad laminate.

Specific examples of the method of molding under heat and pressure include a method of molding under heat and pressure with a vacuum press under conditions of a vacuum degree of preferably 300 kPa or less, and more preferably 100 kPa or less, a temperature of preferably 130 to 350°C, more preferably 150 to 300°C, and further preferably 170 to 250°C, and a pressure of preferably 0.5 to 10 MPa, more preferably 1 to 5 MPa, and further preferably 2 to 5 MPa. The molding under heat and pressure allows the thermosetting resin composition to flow into the non-impregnated region with the thermosetting resin composition in the fiber substrate, and as a result, voids tend to be suppressed from occurring.

It is also possible that the metal foil is removed from the metal-clad laminate of the present embodiment by an etching treatment or the like, and thereby a laminate having no metal foil can be obtained.

### [Method for producing Printed Wiring Board]

The present disclosure also provides a method for producing a printed wiring board including forming a wiring pattern on a laminate produced by the production method described above.

Examples of the method of forming a wiring pattern include known processes, such as a subtractive process, a full additive process, a semi-additive process (SAP), and a modified semi-additive process (m-SAP).

### [Method for producing Semiconductor Package]

The present disclosure also provides a method for producing a semiconductor package including mounting a semiconductor device on a printed wiring board obtained by the production method described above, and then encapsulating the semiconductor device with an encapsulation resin. Specifically, it is possible that by the known method, a semiconductor device, such as a semiconductor chip and a memory chip, is mounted on a prescribed positions on the printed wiring board obtained by the production method described above, and then the semiconductor device is encapsulated with an encapsulation resin or the like, thereby producing a semiconductor package.

### Examples

The present embodiment will be described in more detail with reference to examples below, but the examples do not limit the contents of the present disclosure and the present embodiment.

The prepregs produced in the examples were measured for the surface waviness according to the following method. The results are shown in Table 1.

### (Measurement Method of Surface Waviness)

The shape measurement was automatically performed with the observation application of a profile analysis laser microscope "VK-X100" (available from Keyence Corporation) to provide a waviness curve according to ISO 4287 (1997). The resulting waviness curve was analyzed for the surface roughness with the analysis application thereof to calculate the surface waviness (Wa). The waviness curve herein is a curve obtained by removing the component having a wavelength of less than 80 µm from the cross sectional curve by applying a phase compensation high-pass filter λc (λc = 80 µm) on the cross sectional curve. The analysis region was 1,000 µm × 1,000 µm.

The surface waviness (Wa) was measured for both surfaces of the prepreg, and the larger value was used.

The copper-clad laminates produced in the examples were evaluated according to the following method.

### (1. Evaluation Method of Yield in producing Copper-clad Laminate)

Five plies of the copper-clad laminates were prepared for each of the examples. As the fracture of the internal glass film was able to be confirmed from above the copper foil as shown in Fig. 4, the appearance was visually observed from above the copper foil, and the number of the glass films that were not fractured out of five plies was counted.

### (2. Evaluation Method of Handleability of Copper-clad Laminate)

A piece of 250 mm in length × 250 mm in width was cut out from each of the copper-clad laminates obtained in the examples to prepare an evaluation substrate. As shown in Fig. 5, the evaluation substrate was disposed on a pedestal in such a manner that a portion of 60 mm from the edge thereof was in contact with the pedestal, and while pressing the end portion of the evaluation substrate onto the pedestal with a finger, the evaluation substrate was allowed to warp with the own weight thereof.

The evaluation substrate after the aforementioned operation was visually observed for the appearance, and evaluated according to the following evaluation standard.
A: The glass film was not fractured.
C: The glass film was fractured.

### (3. Evaluation Method of Cutting Processability of Copper-clad Laminate)

The copper-clad laminate obtained in each of the examples was cut into a size of 40 mm in length × 40 mm in width with a compact precision cutter "IsoMet LS" (available from Buehler Ltd.) to produce an evaluation substrate. The cut surface of the evaluation substrate was visually observed for confirming the presence of fracture and chipping, and evaluated according to the following evaluation standard.
A: The cut surface had no fracture nor chipping of the substrate.
C: The cut surface had fracture or chipping of the substrate.

### Production Example 1

### (1-1. Production of Resin Varnish A)

Sixty parts by mass of a phenol-novolac type epoxy resin "Epiclon (registered trademark) N-770" (available from DIC Corporation, epoxy equivalent: 188 g/eq), 40 parts by mass of a biphenyl-aralkyl type phenol resin (available from Ube Industries, Ltd., trade name: MEH-7700), 17.5 parts by mass of aluminum hydroxide, 86 parts by mass of fused silica, 0.5 part by mass of 2-methylimidazole, and methyl isobutyl ketone and cyclohexanone as diluent solvents were added and mixed to produce a resin varnish A with white color having a solid concentration of 65% by mass (content of aluminum hydroxide: 8% by volume, content of fused silica: 32% by volume).

### Production Example 2

### (2-1. Production of Modified Maleimide Resin)

In a reaction vessel having a capacity of 2 L capable of being heated and cooled equipped with a thermometer, an agitation device, and a water quantitative meter having a reflux condenser, 595.8 g of bis(4-maleimidophenyl)methane, 54.2 g of 4,4'-diaminodiphenylmethane, and 350.0 g of propylene glycol monomethyl ether were placed and then reacted for 5 hours under refluxing, so as to provide a solution of a modified maleimide resin.

### (2-2. Production of Resin Varnish B)

Added were 107 parts by mass of the solution of a modified maleimide resin above, 30 parts by mass of a tetrafunctional naphthalene type epoxy resin "EXA-4710" (available from DIC Corporation), 17.5 parts by mass of aluminum hydroxide, 130 parts by mass of fused silica, 0.5 part by mass of 2,4-diamino-6-[2'-methylimidazolyl-(1')]ethyl-s-triazine, and methyl isobutyl ketone and cyclohexanone as diluent solvents, and mixed to produce a resin varnish B with brown color having a solid concentration of 65% by mass (content of aluminum hydroxide: 8% by volume, content of fused silica: 41.5% by volume).

### Example 1

### (1. Production of Resin Film)

The resin varnish A obtained in Production Example 1 was coated on a PET film (available from Toyobo Film Solutions, Ltd., thickness: 50 µm, a release film, trade name: G2) with a comma coater. At this time, the coating amount was regulated to make a coating width of 530 mm and a thickness after drying of 11 µm. Thereafter, the resin varnish was dried by heating to 130°C for 2 minutes to produce a resin film A with a PET film.

### (2. Production of Prepreg)

The resin films A with a PET film were disposed on both surfaces of a glass cloth "IPC #1017" (available from Nitto Boseki Co., Ltd., basis weight: 13 g/m², substrate width: 530 mm, thickness: 15 µm) in such a manner that the surface of the resin layer of the resin film with a PET film was brought into contact with the glass cloth.

The laminate of "PET film/resin film A/glass cloth/resin film A/PET film" was molded under heat and pressure in vacuum with a vacuum laminator. According to the procedure, a prepreg with a PET film having the glass cloth impregnated with the thermosetting resin composition of the resin film was obtained. The condition of vacuum lamination was a heating platen temperature of 130°C, a pressurizing pressure of 0.5 MPa, a vacuum degree of 100 kPa or less, and a vacuum time of 30 seconds. The PET film was released from the resulting prepreg with a PET film, so as to provide a prepreg 1 having a thickness of 25 µm having an impregnated region and a non-impregnated region with the thermosetting resin composition in the fiber substrate.

The thickness of the prepreg 1 was the average value of values obtained by measuring optional 5 positions with a horizontal pedestal and Digimatic Indicator (available from Mitutoyo Corporation).

### (3. Production of Laminated Article and Copper-clad Laminate)

One ply of the resulting prepreg 1 was disposed on each of both surfaces of one ply of a glass film (thickness: 150 µm, available from Nippon Electric Glass Co., Ltd.) to produce a laminated article. A copper foil having a thickness of 3 µm "MT18Ex" (available from Mitsui Mining And Smelting Co., Ltd., having a carrier copper foil having a thickness of 18 µm) was disposed on each of both sides of the laminated article. Subsequently, the assembly was pressed under the following condition to produce a copper-clad laminate 1 "copper foil/prepreg 1/glass film/prepreg 1/copper foil" (see Fig. 6).

The resulting copper-clad laminate 1 was subjected to the aforementioned evaluation. The results are shown in Table 1.

### - Press Condition -

Heating condition: heating from 25°C to 185°C at heating rate of 3°C/min, retaining at 185°C for 90 minutes, and then cooled for 30 minutes

Pressure condition (pressure applied to prepregs held with copper foils): 4 MPa (from start of heating to end of cooling)

### Example 2

A resin film B with a PET film was produced by performing the same operation as in the section "1. Production of Resin Film" in Example 1 except that the resin varnish B obtained in Production Example 2 was used instead of the resin varnish A.

A prepreg 2 having a thickness of 25 µm was obtained by performing the same operation as in the section "2. Production of Prepreg" in Example 1 except that the resin film B with a PET film was used instead of the resin film A with a PET film.

A copper-clad laminate 2 "copper foil/prepreg 2/glass film/prepreg 2/copper foil" (see Fig. 6) was produced by performing the same operation as in the section "3. Production of Laminated Article and Copper-clad Laminate" in Example 1 except that the prepreg 2 was used instead of the prepreg 1, and the heating condition in the press condition was changed to "heating from 25°C to 230°C at heating rate of 3°C/min, retaining at 230°C for 90 minutes, and then cooled for 30 minutes".

The resulting copper-clad laminate 2 was subjected to the aforementioned evaluation. The results are shown in Table 1.

### Comparative Example 1

A glass cloth "IPC #1017" (available from Nitto Boseki Co., Ltd., basis weight: 13 g/m², substrate width: 530 mm, thickness: 15 µm) was immersed in the resin varnish A prepared in Production Example 1, and then after taking out therefrom, was dried under heat at 140°C for 3.5 minutes to provide a prepreg X (thickness: 25 µm). A copper-clad laminate X "copper foil/prepreg X/glass film/prepreg X/copper foil" (see Fig. 7) was produced by performing the same operation as in the section "3. Production of Laminated Article and Copper-clad Laminate" in Example 1 except that the prepreg X was used instead of the prepreg 1. The resulting copper-clad laminate X was subjected to the aforementioned evaluation. The results are shown in Table 1.

### Comparative Example 2

A glass cloth "IPC #2116" (available from Nitto Boseki Co., Ltd., basis weight: 104 g/m², substrate width: 530 mm, thickness: 91 µm) was immersed in the resin varnish B prepared in Production Example 2, and then after taking out therefrom, was dried under heat at 140°C for 3.5 minutes to provide a prepreg Y (thickness: 25 µm). A copper-clad laminate Y "copper foil/prepreg Y/glass film/prepreg Y/copper foil" (see Fig. 7) was produced by performing the same operation as in the section "3. Production of Laminated Article and Copper-clad Laminate" in Example 2 except that the prepreg Y was used instead of the prepreg 2. The resulting copper-clad laminate Y was subjected to the aforementioned evaluation. The results are shown in Table 1.

### Comparative Example 3

A copper-clad laminate Z "copper foil/resin film A/E glass film/resin film A/copper foil" (see Fig. 8) was produced by performing the same operation as in the section "3. Production of Laminated Article and Copper-clad Laminate" in Example 1 except that the resin film A was used instead of the prepreg 1. The resulting copper-clad laminate Z was subjected to the aforementioned evaluation. The results are shown in Table 1.

### [Table 1]

**Table 1**

| | | Example | | Comparative Example | | |
|---|---|---|---|---|---|---|
| | | 1 | 2 | 1 | 2 | 3 |
| | Surface waviness (Wa) of prepreg (µm) | 1.6 | 0.9 | 6.8 | 5.2 | - |
| | Reference number of copper-clad laminate | 1 | 2 | X | Y | Z |
| Evaluation result | 1. Yield in producing copper-clad laminate (ply/5) | 5/5 | 5/5 | 2/5 | 3/5 | 3/5 |
| | 2. Handleability of copper-clad laminate | A | A | A | A | C |
| | 3. Cutting processability of copper-clad laminate | A | A | A | A | C |

It is understood from the results in Table 1 that the copper-clad laminates produced in Examples 1 and 2 exhibit a high yield as the internal glass film is not fractured in production. The copper-clad laminates produced in Examples 1 and 2 are excellent in handleability and also excellent in cutting processability, and have high industrial usefulness.

On the other hand, the copper-clad laminates produced in Comparative Examples 1 and 2 are excellent in handleability and cutting processability, but exhibit a low yield as the internal glass film is sometimes fractured in production. The copper-clad laminate produced in Comparative Example 3 exhibits a low yield as the internal glass film is frequently fractured in production, and is poor in handleability and cutting processability.

### Reference Sign List

1: glass film
2: prepreg 1 used in Example 1 or prepreg 2 used in Example 2
3: copper foil
4: prepreg X used in Comparative Example 1 or prepreg Y used in Comparative Example 2
5: resin film A used in Comparative Example 3

## Claims

1. A method for producing a laminated article, comprising the following step (1):
(1) disposing a prepreg having a surface waviness (Wa) of 5.0 µm or less, on one surface or both surfaces of a glass film, so as to produce a laminated article.

2. The method for producing a laminated article according to claim 1, wherein the prepreg used in the step (1) is produced by impregnating a fiber substrate with a thermosetting resin film.

3. The method for producing a laminated article according to claim 1, wherein in the step (1), the glass film has a thickness of 50 to 1,000 µm.

4. The method for producing a laminated article according to claim 1, wherein in the step (1), the prepreg has a thickness of 10 to 300 µm.

5. A method for producing a laminate, comprising the following steps (1) and (2) in this order:
(1) disposing a prepreg having a surface waviness (Wa) of 5.0 µm or less, on one surface or both surfaces of a glass film, so as to produce a laminated article, and
(2) disposing a metal foil on one surface or both surfaces of the laminated article, and then molding under heat and pressure, so as to produce a laminate.

6. The method for producing a laminate according to claim 5, wherein the method further comprises the following step (1') between the step (1) and the step (2):
(1') disposing a glass film on one surface or both surfaces of the laminated article obtained in the step (1), and then disposing the prepreg on the glass film, or repeating the step (1') twice or more, so as to produce a laminated article.

7. A method for producing a printed wiring board, comprising forming a wiring pattern on a laminate produced by the production method according to claim 5.

8. A method for producing a semiconductor package, comprising mounting a semiconductor device on a printed wiring board obtained by the production method according to claim 7, and then encapsulating the semiconductor device with an encapsulation resin.
